# EUROPÄISCHE PATENTSCHRIFT

(11) **EP 2 061 917 B1**
(45) Veröffentlichungstag und Bekanntmachung des Hinweises auf die Patenterteilung: **06.12.2017**
(21) Anmeldenummer: 07800628.5
(22) Anmeldetag: 04.09.2007
(51) Int. Cl.: C25F 7/00

(54) **ENTSCHICHTUNGSANLAGE UND VERFAHREN ZU IHREM BETRIEB**
COATING REMOVAL INSTALLATION AND METHOD OF OPERATING IT
INSTALLATION D'ENLEVEMENT DE COUCHE ET PROCEDE POUR SON UTILISATION

(30) Priorität: 05.09.2006 CH 14142006
(43) Veröffentlichungstag der Anmeldung: 27.05.2009
(73) Patentinhaber: Oerlikon Trading AG, Trübbach, 9477 Trübbach (CH)
(72) Erfinder: BAERTSCH, Hanspeter, CH-8887 Mels (CH); EGGER, Sven, CH-8889 Plons (CH); WURZER, Manfred, CH-9303 Wittenbach (CH); REYHER, Torsten, CH-7074 Malix (CH); LASCH, Kerstin, A-6700 Bludenz (AT); RAUCH, Udo, A-6824 Schlins (AT)
(74) Vertreter: Wagner, Wolfgang Heribert
(86) Internationale Anmeldenummer: PCT/CH2007/000437
(87) Internationale Veröffentlichungsnummer: WO 2008/028311

(56) Entgegenhaltungen:
- EP-A2- 1 050 607
- JP-A- 2 166 298
- US-A- 2 645 611
- "Definition: Kupplung" MEYERS LEXIKON ONLINE, [Online] XP002457820 Gefunden im Internet: URL:http://lexikon.meyers.de/meyers/Kupplu ng> [gefunden am 2007-11-07]

## Beschreibung

### Technisches Gebiet

Die Erfindung betrifft eine Entschichtungsanlage und Verfahren zu ihrem Betrieb. Entschichtungsanlagen werden verwendet, um in Beschichtungsanlagen eingesetzte Werkstückträger, die dort zwangsläufig mitbeschichtet werden, von ihrer Beschichtung zu befreien und wieder für den Einsatz tauglich zu machen und auch, um abgenützte oder fehlbeschichtete Werkstücke zu entschichten und damit für eine Neubeschichtung vorzubereiten.

### Stand der Technik

Zum Entschichten von Werkstückträgern werden heute überwiegend mechanische Verfahren eingesetzt, vor allem Sandstrahlen. Dazu müssen die Werkstückträger zerlegt werden. Nach der Behandlung muss der Sand sorgfältig entfernt werden, z.B. durch Abblasen. Trotzdem sind oft Rückstände nicht zu vermeiden, was später zu Funktionsstörungen führen kann. Ausserdem werden die Werkstückträger beim Sandstrahlen ungleichmässig abgenutzt und unterliegen einem beträchtlichen Verschleiss, was ihre Lebensdauer verkürzt.

Zur Entschichtung abgenutzter und fehlbeschichteter Werkstücke werden auch elektrochemische Verfahren eingesetzt, s. z.B. WO 99/54 528 A1. Dazu werden Entschichtungsanlagen gemäss dem Oberbegriff des Anspruchs 1 verwendet. Manche dieser Anlagen weisen auf- und abbewegbare Körbe oder Drehtrommeln zur Aufnahme der Werkstücke auf.

Meist müssen aber die Werkstücke einzeln kontaktiert werden. Dies ist besonders aufwendig bei der Entfernung von Schichten aus nichtleitendem Material, wo die Kontaktierung weiteren Einschränkungen unterliegt und die Werkstücke einzeln an Halterungen montiert werden müssen.

Die Ausbildung und Positionierung der Gegenelektrodenfläche in bekannten gattungsgemässen Entschichtungsanlagen ist schwierig und nicht immer optimal zu bewerkstelligen, da der Stromfluss möglichst gleichmässig über die zu entschichtenden Oberflächenbereiche der Werkstücke verteilt sein soll, damit eine gleichmässige Entschichtung erreicht und Korrosion der die Beschichtung tragenden Grundkörper vermieden wird.

Aus US 2 645 611 A ist eine im Aufbau gattungsgemässe Anlage zum Polieren von Gegenständen aus Metall, insbesondere aus bestimmten Legierungen, bekannt, bei der gemäss einer ersten Ausführungsform die den Elektrolyten enthaltende Wanne zugleich die Gegenelektrode bildet. Bei einer weiteren Ausführungsform ist die Wanne aus Glas und die Gegenelektrode, als Kupferplatte ausgebildet, knapp über dem Boden der Wanne angeordnet.

### Darstellung der Erfindung

Der Erfindung liegt die Aufgabe zu Grunde, gattungsgemässe Entschichtungsanlagen so weiterzubilden, dass der Prozess der Entschichtung wesentlich vereinfacht ist und mit grosser Zuverlässigkeit und Gleichmässigkeit ausgeführt werden kann. Diese Aufgabe wird durch die Merkmale im Kennzeichen des Anspruchs 1 erfüllt. Darüberhinaus werden Verfahren zum Betrieb einer erfindungsgemässen Entschichtungsanlage angegeben, mit welchen Entschichtungen und auch neben der Entschichtung noch weitere Schritte umfassende komplexere Prozesse in einfacher Weise ausgeführt werden können.

Vorteile der Erfindung liegen vor allem darin, dass die Entschichtung von Werkstückträgern wesentlich einfacher und schonender erfolgen kann. Da mechanische Bearbeitung weitgehend vermieden werden kann, ist ihre Lebensdauer wesentlich grösser. Nachbehandlung ist allenfalls in geringem Umfang nötig (Spülen, Sprühen, Trocknen) und erfordert kaum Handarbeit. Darüberhinaus ist aber auch die Entschichtung abgenützter und fehlbeschichteter Werkstücke wesentlich vereinfacht und weitaus zuverlässiger zu bewerkstelligen. Durch Drehung des Werkstückträgers kann - über die Bearbeitungszeit gemittelt - leichter eine über die Oberflächen der Werkstücke einigermassen gleichmässige Stromdichte erzielt werden. Vor allem bei Werkstücken mit nichtleitender Beschichtung ist die Handhabung meist wesentlich vereinfacht, da die Werkstücke bei der Entschichtung in genau gleicher Weise kontaktiert werden wie bei der Beschichtung.

Vor allem wenn fehlbeschichtete Werkstücke entschichtet und neu beschichtet werden sollen, kann der Handhabungsaufwand wesentlich vermindert werden, wenn die Werkstücke gemäss erfindungsgemässen Verfahren bearbeitet werden. Zur Entschichtung bleiben sie in diesem Fall auf dem Werkstückträger, auf dem sie ursprünglich beschichtet wurden. Eine Abnahme und Neumontage unterbleibt, da der Werkstückträger mit den montierten und kontaktierten Werkstücken von einer Beschichtungsanlage zur erfindungsgemässen Entschichtungsanlage verbracht und in diese eingesetzt wird. Im Fall einer Neubeschichtung der Werkstücke wird in gleicher Weise nach der Entschichtung der Werkstückträger mit den Werkstücken in eine Beschichtungsanlage verbracht und in diese eingesetzt, worauf die Werkstücke neu beschichtet werden. Eine direkte Handhabung der Werkstücke kann dabei unterbleiben.

### Kurze Beschreibung der Zeichnungen

Im folgenden wird die Erfindung anhand einer Figur, welche lediglich ein Ausführungsbeispiel darstellt, näher erläutert.

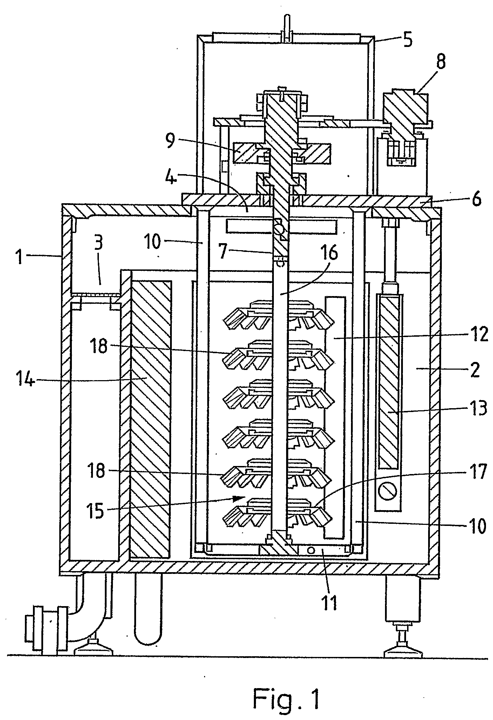

- Fig. 1: zeigt einen vertikalen Schnitt durch eine erfindungsgemässe Entschichtungsanlage.

### Wege zur Ausführung der Erfindung

Die erfindungsgemässe Entschichtungsanlage umfasst ein quaderförmiges Gehäuse 1, das eine Wanne 2 enthält, welche aus nichtleitendem Material besteht oder an der Innenseite mit einem nichtleitenden Material beschichtet ist, sodass die Innenwand nichtleitend ist. Sie dient zur Aufnahme eines flüssigen Elektrolyten. Neben der Wanne 2 ist ein Ueberlauf 3 mit einem Sieb oder Filter angeordnet. An der Oberseite weist das Gehäuse 1 eine Oeffnung 4 auf.

Eine Halterung 5 umfasst eine Grundplatte 6, mit welcher sie auf dem Gehäuse 1 abgestützt ist sowie eine Kupplung 7, die in der Grundplatte 6 drehbar gelagert ist. Ihre Drehachse läuft senkrecht etwa mittig durch die Wanne 2. Mit der Kupplung 7 wirkverbunden ist eine Antriebseinrichtung 8, welche als Elektromotor ausgebildet ist. Die Halterung 5 umfasst ebenfalls eine zweipolige Stromversorgungseinrichtung (nicht dargestellt), deren einer Pol über eine Stromübertragungsvorrichtung 9 mit der Kupplung 7 elektrisch leitend verbunden ist. Sie kann als Stromquelle, Spannungsquelle, Pulsstromquelle oder Pulsspannungsquelle oder auch als Wechselstromversorgung ausgebildet sein. Die Halterung 5 ist so mit dem Gehäuse 1 verbunden, dass sie ohne grossen Aufwand abgenommen, z.B. einfach abgehoben werden kann. Die Stromversorgungseinrichtung kann auch extern sein, sodass die Entschichtungsanlage lediglich Anschlüsse zur Verbindung mit derselben aufweist, deren einer mit der Stromübertragungsvorrichtung 9 verbunden ist. Ausserdem ist ein die Drehachse umgebendes Gestell mit mehreren parallelen an der Grundplatte 6 verankerten Stangen 10 vorgesehen, an deren Enden eine Querstrebe 11 gehaltert ist.

Der andere Pol der Stromversorgungseinrichtung oder der andere Anschluss ist mit einer z.B. als Gitterelektrode ausgebildeten Gegenelektrode 12 verbunden, die im Inneren der Wanne 2 angeordnet ist. Die Gegenelektrode 12 weist eine der Drehachse zugewandte und von ihr überall etwa gleich weit entfernte, sich im wesentlichen über die ganze Höhe der Wanne 2 erstreckende Gegenelektrodenfläche auf. Letztere kann z.B. die Form einer konkaven Zylindermantelfläche haben, deren Achse mit der Drehachse zusammenfällt und die sich über einen kleineren oder grösseren Sektor von z.B. 90° bis 180° erstreckt. Doch kann die Gegenelektrode auch als Stabelektrode ausgebildet sein. In der Wanne 2 sind ausserdem eine Heiz- und Kühlvorrichtung 13 angeordnet und ein Ultraschallgeber 14 sowie ein Einlass für den Elektrolyten und Einrichtungen zur Bewegung desselben wie Pumpen oder Rührer (nicht dargestellt).

Im Betrieb ist die Wanne 2 bis mindestens nahe an den oberen Rand mit einem flüssigen Elektrolyten gefüllt. Mit der Kupplung 7 ist ein im Beispiel als Bäumchen ausgebildeter Werkstückträger 15 drehfest verbunden, und zwar ein in der Drehachse liegender zentraler Schaft 16 desselben, an welchem, in regelmässigen Abständen aufeinanderfolgend, Teller 17 befestigt sind, die, jeweils über ihre Peripherie verteilt, Werkstücke 18 tragen. Für die Ausbildung der Verbindung zwischen der Kupplung 7 und dem Schaft 16 gibt es verschiedene Möglichkeiten. Bevorzugt werden schnell herstellbare und lösbare Verbindungen wie Steckverbindungen oder Bajonettverbindungen. Die Spitze des Schaftes 16 ist an der Querstrebe 11 drehbar gelagert. Ueber die Kupplung 7 ist der Schaft 16 mit dem ersten Pol der Stromversorgungseinrichtung verbunden und über denselben auch die Teller 17. Die Werkstücke 18 sind an den Tellern 17 befestigt und kontaktiert, sodass sie ebenfalls mit dem ersten Pol der Stromversorgungseinrichtung elektrisch leitend verbunden sind. Der Werkstückträger 15 wie auch alle anderen in der Wanne 2 angeordneten Komponenten der Entschichtungsanlage müssen aus einem Werkstoff bestehen, der vom Elektrolyten nicht angegriffen wird, gewöhnlich aus rostfreiem Stahl oder, wo dies nicht möglich ist, wie bei manchen magnetischen Werkstoffen, in rostfreier Folie gekapselt sein.

Der Werkstückträger kann auch anders als beschrieben ausgebildet sein, im Grunde kann jede Art von um eine Drehachse drehbarem Werkstückträger eingesetzt werden, die in Beschichtungsanlagen, insbesondere Vakuumbeschichtungsanlagen zum Einsatz kommt, z.B. Bäumchen mit Mehrfachrotation, wobei etwa an den Stangen 10 Mitnehmerfinger montiert sein können oder auch Werkstückträger anderen Typs mit Magnet- oder Steckplatten. Die Befestigung der Werkstücke kann in der in Vakuumbeschichtungsanlagen üblichen Weise, z.B. durch Steck- oder Klemmverbindungen oder magnetisch erfolgen.

Die Stromversorgungseinrichtung erzeugt nun eine intermittierende oder permanente Potentialdifferenz zwischen dem als Elektrode wirkenden Werkstückträger 15 und den über ihn kontaktierten Werkstücken 18 einerseits und der Gegenelektrode 12 andererseits. Dabei sind - wo anwendbar - gewöhnlich die Elektrode als Anode und die Gegenelektrode als Kathode geschaltet. Zugleich wird die Kupplung 7 durch die Antriebseinrichtung 8 gleichmässig gedreht und mit ihr der Werkstückträger 15, wobei die Drehgeschwindigkeit an den Prozess angepasst ist. Die Werkstücke 18 werden dabei nahe an der Gegenelektrodenfläche vorbeibewegt, vorzugsweise mit einem Mindestabstand von zwischen 2cm und 20cm, vorzugsweise zwischen 3cm und 8cm. Die Entschichtung erfolgt nun in der Regel durch elektrochemische Auflösung der Beschichtung sowohl des Werkstückträgers 15 wie auch der Werkstücke 18. Wegen der Rotation des Werkstückträgers 15 ist die Stromdichte im zeitlichen Mittel ziemlich gleichmässig, d.h. der Strom ist gleichmässig über die zu entschichtenden Flächen verteilt und die Entschichtung erfolgt entsprechend gleichmässig und schonend. Dazu trägt auch bei, dass alle Teile der Gegenelektrodenfläche etwa gleich weit von der Drehachse und damit vom Schaft 16 entfernt sind.

Es ist auch möglich, dass die Beschichtung aus einer direkt auf dem Grundkörper abgeschiedenen Haftschicht und einer auf dieser abgeschiedenen Funktionsschicht besteht und die Entschichtung durch Auflösung der Haftschicht durch Poren der Funktionsschicht hindurch erfolgt, wie das z.B. in WO 99/64 646 A1 und WO 05/073 433 A1 beschrieben ist. Vor allem in solchen Fällen kann der Entschichtungsvorgang durch Einsatz des Ultraschallgebers 14 wesentlich beschleunigt und verbessert werden.

Mit der erfindungsgemässen Entschichtungsanlage sind verschiedene Betriebsweisen möglich. So kann sie etwa zur Entschichtung eines Werkstückträgers 15 allein, d.h. eines unbestückten Werkstückträgers, eingesetzt werden. Oder sie kann zur Entschichtung von vorher in einer Beschichtungsanlage, insbesondere einer Vakuumbeschichtungsanlage fehlbeschichteten Werkstücken eingesetzt werden. In diesem Fall kann etwa die Halterung 5 samt Werkstückträger 15 und Werkstücken 18 aus der Beschichtungsanlage entnommen und in die Entschichtungsanlage eingesetzt werden, ohne dass sonst irgendwelche Manipulationen an diesen Teilen vorgenommen werden müssten.

Gleich kann bei einer Neubeschichtung nach erfolgter Entschichtung vorgegangen werden. In diesem Fall kann die Halterung 5 zusammen mit dem Werkstückträger 15 und den Werkstücken 18 vom Gehäuse 1 der Entschichtungsanlage abgenommen und in eine Beschichtzungsanlage, insbesondere Vakuumbeschichtungsanlage verbracht und in deren Vakuumkammer eingesetzt und z.B. im CVD- oder PVD-Verfahren beschichtet werden. Dabei können in einer Mehrkammeranlage auch zwischen Entschichtung und Neubeschichtung andere Schritte in geeigneten Kammern ausgeführt werden wie Spülen, Sprühen und Trocknen, alles ohne dass der Werkstückträger 15 von der Halterung 5 getrennt werden müsste oder gar die Werkstücke 18 abgenommen werden müssten. Natürlich können auch nach einer Fehlbeschichtung Entschichtung und Neubeschichtung in dieser Weise hintereinander ausgeführt werden. Zum Verschieben der Halterung 5 zwischen den Kammern kann eine geeignete Transporteinrichtung vorgesehen sein. Auf diese Weise können auch komplexe Prozesse mit mehreren Bearbeitungsschritten weitgehend automatisiert werden.

Alternativ ist es möglich, jeweils den mit den Werkstücken 18 bestückten Werkstückträger 15 allein wie beschrieben zu verschieben, wobei er an die Kupplung 7 und entsprechende Kupplungen in den übrigen Kammern angesetzt bzw. von ihnen abgehängt werden muss. Dies ist etwas aufwendiger, doch sind gegebenenfalls die Anforderungen an die Transportvorrichtung geringer.

Es sind auch viele Abwandlungen der beschriebenen Entschichtungsanlage möglich. So können in der Wanne mehrere Kupplungen für mehrere Werkstückträger vorgesehen sein. Die Kupplung kann statt oberhalb der Wanne oder in ihrem oberen Bereich auch an ihrem Boden angeordnet sein. Die Wanne kann so ausgebildet sein, dass auch andere Prozessschritte wie Spülen, Sprühen und Trocknen in ihr ausgeführt werden können. Dazu können Pumpen und ein Auffangvolumen zur zeitweiligen Entfernung des Elektrolyten vorgesehen sein.

Im folgenden werden einige Beispiele für mögliche Ausbildungen von erfindungsgemässen Entschichtungsanlagen und Verfahren, bei denen sie eingesetzt wurden, gegeben:
1. Halterungen für Steuerkolben, die nach wiederholtem Einsatz in Beschichtungsprozessen zur Abscheidung von DLC-und CrN/DLC-Schichten mit einer bis zu 100 µm dicken Multilagenschicht beschichtet waren, wurden auf mehreren im Boden einer Wanne angebrachten drehbaren Kupplungen bäumchenweise beschickt. Die einzelnen Bäumchen wurden jeweils an einer im Kontaktbereich elektrisch leitenden Kupplung befestigt, die Mitnehmer ähnlich wie in PVD Anlagen an die Satelliten angestellt und anschliessend die Wanne mit einem kalilaugehaltigen, mit Phosphaten und Tensiden versetzten Elektrolyten mit einem pH-Wert von 11 bis 13 aufgefüllt. Bei konstanter Umdrehung wurde das Bäumchen mit doppeldrehenden Satelliten bei Raumtemperatur und konstanter Spannung von +12V innerhalb von 1h entschichtet. Der Angriff des Elektrolyten erfolgte dabei jeweils durch die Poren der DLC-Schicht hindurch auf die CrN- bzw. die unter dem DLC als Haftschicht abgeschiedene dünne Cr-Schicht.
2. Bäumchen mit doppeldrehenden Satelliten für Tassenstössel, die nach wiederholtem Einsatz mit DLC- und CrN/DLC-Schichten beschichtet waren, wurden ähnlich wie in Beispiel 1, unter Verwendung desselben Elektrolyten, bei konstantem Strom von 200A, bei Raumtemperatur innerhalb von 1h entschichtet. Statt eines Antriebs durch Mitnehmerfedern wurde hierbei die zweifache Rotation mittels Zahnrädern und Zahnkränzen bewirkt.
3. Fehlerhaft beschichtete Steuerkolben, die mit einer DLC-, einer auf einer Cr-Haftschicht abgeschiedenen WC/C-Schicht oder mit einer CrN/DLC-Doppelschicht beschichtet waren, wurden wie für einen PVD-Beschichtungsprozess auf Satellitenteller und Bäumchen chargiert. Je nach Grösse der Steuerkolben wurden Teller mit einer unterschiedlichen Teilung verwendet. Die Bäumchen wurden nacheinander in einer Einbäumchenvorrichtung auf einer im Boden einer Wanne angebrachten Kupplung befestigt und nach dem Anstellen von Mitnehmerfedern in den alkalischen Elektrolyten von Beispiel 1 getaucht. Bei konstanter doppelter Satellitendrehung und konstantem Strom von 250A wurden die Bäumchen bei Raumtemperatur innerhalb von 10min entschichtet.
4. In der in Beispiel 3 verwendeten Vorrichtung wurden auf Satellitenbäumchen chargierte CrN+DLC-beschichtete Lager-und Kolbenbolzen im selben Elektrolyten wie in Beispiel 1 bei konstanter Spannung von 15V in 5min entschichtet.
5. HSS-Bohrer und -Fräser, sowie andere HSS-Werkzeuge, die mit unterschiedlichen chromhaltigen Schichtsystemen wie Balinit Alcrona (Aluminiumchromnitrid), Balinit Helica (Aluminiumchromsiliziumnitrid), Balinit C (Cr+WC/C), Balinit DLC (Cr+DLC) und Balinit D (CrN) beschichtet waren, wurden gemeinsam auf Satellitenteller chargiert und analog Beispiel 3 bäumchenweise in die Wanne eingebaut. Nach Eintauchen in den alkalischen Elektrolyten von Beispiel 1 wurden die Werkzeuge bei Raumtemperatur unter konstanter zweifacher Drehung bei einem Strom von 250A innerhalb von 30min entschichtet.
6. Eine ähnliche Mischung unterschiedlich beschichteter Werkzeuge wurde wie in Beispiel 5 eingebaut und anschliessend in einprozentiger Natronlauge und konstanter Spannung von 12V unter sonst gleichen Bedingungen in 25min entschichtet.
7. Zwei mit Balinit Alcrona beschichtete HSS-Wälzfräser wurden auf einen Baum chargiert und dieser in den Elektrolyten von Beispiel 6 getaucht. Bei konstanter einfacher Umdrehung wurden sie bei einer konstanten Spannung von 12V innerhalb von 20min entschichtet.
8. Ein Teller mit Bohrern und Fräsern, die mit Balinit Futura-Nano (TiAlN) und Balinit Alcrona (AlCrN) beschichtet waren, wurden auf ein Bäumchen chargiert und in eine Vorrichtung gemäss Fig. 1 über Kopf eingesetzt und in den Elektolyten von Beispiel 1 getaucht. Bei konstanter einfacher Umdrehung wurde bei einer konstanten Spannung von 6V innerhalb von 3min die Oberfläche durch Bildung einer dünnen Schicht eines Aluminiumoxids mit einer oxonitridhaltigen Übergangszone zur TiAlN-Schicht modifiziert.
9. Hartmetallwerkzeuge, die mit unterschiedlichen Schichtsystemen wie Balinit Futura (Titanaluminiumnitrid), Balinit Xceed (hochaluminiumhaltiges TiAlN), Balinit AlCrona (AlCrN) und Balinit Helica (Aluminiumchromsiliziumnitrid) beschichtet waren, wurden gemeinsam auf Satellitenteller chargiert und analog Beispiel 8 bäumchenweise in einem Elektolyten aus Ammoniumnitrat und Essigsäure mit einem pH-Wert von 1,5 bis 3 getaucht. Bei konstanter einfacher Umdrehung wurden die Werkzeuge bei einer Spannung von 15V innerhalb von 5min entschichtet.
10. Bäumchen mit beschichteten Bolzen, die mit einer prozessbedingt fehlerhaften Doppelschicht bestehend aus CrN+WC/C beschichtet waren, wurden direkt aus der PVD-Beschichtungsanlage entnommen und in eine Vorrichtung analog und unter denselben Bedingungen wie in Beispiel 3 entschichtet. Danach wurden die Bäumchen mit den Bolzen in der Wanne mehrfach sprühgereinigt und mit Warmluft getrocknet. Anschliessend wurden die Bäumchen zur Neubeschichtung direkt in die PVD-Beschichtungsanlage eingebaut.

Ausser für Entschichtung kann die erfindungsgemässe Anlage auch für andere elektrochemische Verfahren eingesetzt werden, z.B. zum Modifizieren von Beschichtungen wie in Beispiel 8 oder zum Polieren oder Oxidieren von Oberflächen von Werkstücken, definierte Kantenverrundung an Schneidwerkzeugen u.a.. Auch solche Verfahren werden durch die Rotation des Werkstückträgers vergleichmässigt. Ausserdem können sie besser mit anderen Schritten eines komplexen Prozesses koordiniert werden.

### Bezugszeichenliste

- 1: Gehäuse
- 2: Wanne
- 3: Ueberlauf
- 4: Oeffnung
- 5: Halterung
- 6: Grundplatte
- 7: Kupplung
- 8: Antriebseinrichtung
- 9: Stromübertragungsvorrichtung
- 10: Stangen
- 11: Querstrebe
- 12: Gegenelektrode
- 13: Heiz- und Kühlvorrichtung
- 14: Ultraschallgeber
- 15: Werkstückträger
- 16: Schaft
- 17: Teller
- 18: Werkstücke

## Patentansprüche

1. Entschichtungsanlage mit einer Wanne (2) zur Aufnahme eines flüssigen Elektrolyten, einer im Inneren der Wanne (2) angeordneten, an einen Pol einer Stromversorgungseinrichtung anschliessbaren Gegenelektrodenfläche, einer Halterung (5) mit einer um eine Drehachse, welche durch das Innere der Wanne (2) läuft, drehbar gelagerten Kupplung (7) zum Ansetzen eines Werkstückträgers (15), welche zur Ermöglichung des Anschlusses eines solchen Werkstückträgers (15) an einen weiteren Pol der Stromversorgungseinrichtung anschliessbar ist sowie mit einer mit der Kupplung (7) wirkverbundenen Antriebseinrichtung (8) zum Drehen der Kupplung (7), **dadurch gekennzeichnet, dass** die Gegenelektrodenfläche ein der Drehachse zugewandter Teil der Oberfläche mindestens einer im Inneren der Wanne (2) angeordneten, von deren Innenwand beabstandeten Gegenelektrode (12) ist und alle Teile der Gegenelektrodenfläche ungefähr gleich weit von der Drehachse entfernt sind.

2. Entschichtungsanlage nach Anspruch 1, **dadurch gekennzeichnet, dass** die Drehachse senkrecht ist.

3. Entschichtungsanlage nach Anspruch 1 oder 2, **dadurch gekennzeichnet, dass** die Kupplung (7) oberhalb der Wanne (2) oder im oberen Teil derselben angeordnet ist.

4. Entschichtungsanlage nach Anspruch 3, **dadurch gekennzeichnet, dass** die Halterung (5) von der Wanne (2) abnehmbar ist.

5. Entschichtungsanlage nach einem der Ansprüche 1 bis 4, **dadurch gekennzeichnet, dass** die Innenwand der Wanne (2) aus elektrisch isolierendem Material besteht.

6. Entschichtungsanlage nach einem der Ansprüche 1 bis 5, **dadurch gekennzeichnet, dass** im Inneren der Wanne (2) ein Ultraschallgeber (14) angeordnet ist.

7. Entschichtungsanlage nach einem der Ansprüche 1 bis 6, **dadurch gekennzeichnet, dass** im Inneren der Wanne (2) eine Heiz- und Kühlvorrichtung (13) angeordnet ist.

8. Verfahren zum Betrieb einer Entschichtungsanlage nach einem der Ansprüche 1 bis 7, **dadurch gekennzeichnet, dass** an die Kupplung (7) ein mindestens überwiegend aus elektrisch leitendem Material bestehender Werkstückträger (15) angesetzt wird, das Innere der Wanne mit einem flüssigen Elektrolyten gefüllt wird und dann zur Entschichtung mittels der Stromversorgungseinrichtung an die Kupplung (7) und über diese an den Werkstückträger (15) als Elektrode einerseits und an die Gegenelektrodenfläche andererseits mindestens intermittierend unterschiedliche elektrische Potentiale angelegt werden, während der Werkstückträger (15), im wesentlichen vollständig in den Elektrolyten eingetaucht, durch Drehen der Kupplung (7) mittels der Antriebseinrichtung (8) gedreht wird.

9. Verfahren nach Anspruch 8, **dadurch gekennzeichnet, dass** es sich beim Werkstückträger (15) um einen vorgängig in einer Beschichtungsanlage eingesetzten Werkstückträger handelt.

10. Verfahren nach Anspruch 9 zum Entschichten von Werkstücken (18), **dadurch gekennzeichnet, dass** der Werkstückträger (15) mit den zu entschichtenden Werkstücken (18) bestückt ist.

11. Verfahren nach Anspruch 10, zum Entschichten fehlbeschichteter Werkstücke (18), **dadurch gekennzeichnet, dass** vor der Entschichtung der mit den fehlbeschichteten Werkstücken (18) bestückte Werkstückträger (15) einer Beschichtungsanlage entnommen und in die Entschichtungsanlage eingesetzt wird.

12. Verfahren nach Anspruch 10 oder 11, zum Entschichten und Neubeschichten von Werkstücken (18), **dadurch gekennzeichnet, dass** nach der Entschichtung der mit den Werkstücken (18) bestückte Werkstückträger (15) aus der Entschichtungsanlage entnommen, in eine Beschichtungsanlage eingesetzt und daraufhin die Werkstücke (18) in derselben neu beschichtet werden.

13. Verfahren nach Anspruch 12, **dadurch gekennzeichnet, dass** der mit den Werkstücken (18) bestückte Werkstückträger (15) zwischen der Entschichtung und dem Verbringen in die Beschichtungsanlage mindestens einer Behandlung unterzogen, z.B. gespült, gesprüht, getrocknet wird.

## Claims

1. A coating removal installation having a trough (2) for receiving a liquid electrolyte, a counter electrode surface arranged inside the trough (2) and connectable to a pole of a power supply device, a mounting (5) with a coupling (7) rotatably supported around an axis of rotation running through the interior of the trough (2) for the attachment of a workpiece carrier (15), the coupling being connectable to another pole of the power supply device for enabling the connection of such a workpiece carrier (15), and with a driving device (8) operatively connected to the coupling (7) for rotating the coupling (7), **characterised in that** the counter electrode surface is a part of the surface, facing the axis of rotation, of at least one counter electrode (12) disposed in the interior of the trough (2) and spaced apart from the interior wall thereof, wherein all parts of the counter electrode surface have approximately the same distance from the axis of rotation.

2. The coating removal installation according to claim 1, **characterised in that** the axis of rotation is oriented vertically.

3. The coating removal installation according to claim 1 or 2, **characterised in that** the coupling (7) is arranged above the trough (2) or in the upper part thereof.

4. The coating removal installation according to claim 3, **characterised in that** the mounting (5) can be removed from the trough (2).

5. The coating removal installation according to any one of claims 1 to 4, **characterised in that** the interior wall of the trough (2) is made of an electrically isolating material.

6. The coating removal installation according to any one of claims 1 to 5, **characterised in that** an ultrasonic transducer (14) is disposed in the interior of the trough.

7. The coating removal installation according to any one of claims 1 to 6, **characterised in that** a heating and cooling device (13) is disposed in the interior of the trough (2).

8. A method for operating a coating removal installation according to any one of claims 1 to 7, **characterised in that** a workpiece carrier (15) consisting at least predominantly of electrically conductive material is attached to the coupling (7), the interior of the trough is filled with a liquid electrolyte, and then at least intermittently different electrical potentials are applied, by means of the power supply device and through this to the workpiece carrier (15) as the electrode on the one hand, and to the counter electrode surface on the other hand, to effect the coating removal, while the workpiece carrier (15), substantially fully immersed in the electrolyte, is rotated by rotation of the coupling (7) by means of the driving device (8).

9. The method according to claim 8, **characterised in that** the workpiece carrier (15) is a workpiece carrier previously employed in a coating installation.

10. The method according to claim 9 for removing the coating from work pieces (18), **characterised in that** the workpiece carrier (15) is fitted with the work pieces (18) from which the coating is to be removed.

11. The method according to claim 10 for removing the coating from incorrectly coated work pieces (18), **characterised in that** the workpiece carrier (15) fitted with the incorrectly coated work pieces (18) is removed from a coating installation and introduced into the coating removal installation before the removal of the coating.

12. The method according to claim 10 or 11 for removing the coating from and recoating of work pieces (18), **characterised in that** after the removal of the coating, the workpiece carrier (15) fitted with the work pieces (18) is removed from the coating removal installation and inserted into a coating installation, and the work pieces (18) are subsequently recoated therein.

13. The method according to claim 12, **characterised in that** the workpiece carrier (15) fitted with the work pieces (18) is subjected to at least one treatment, e.g. flushing, spraying, drying, between the removal of the coating and the transfer into the coating installation.

## Revendications

1. Installation d'enlèvement de couche, avec une cuve (2) destiné à recevoir un électrolyte liquide, une surface de contre-électrode disposée à l'intérieur de la cuve (2) et pouvant être connectée à une pôle d'un dispositif d'alimentation électrique, un support (5) comportant un accouplement (7) monté de manière rotative autour d'un axe de rotation traversant l'intérieur de la cuve (2) pour attacher une porte-pièces (15), l'accouplement pouvant être relié à un autre pôle du dispositif d'alimentation électrique pour permettre la connexion d'une telle porte-pièces (15), et un dispositif d'entraînement (8) relié de façon opérationnelle à l'accouplement (7) et destiné à faire tourner l'accouplement (7), **caractérisée en ce que** la surface de contre-électrode est une partie de surface faisant face à l'axe de rotation d'au moins une contre-électrode (12) disposée à l'intérieur de la cuve (2) et espacée de la paroi intérieure de celle-ci, et toutes les parties de la surface de contre-électrode sont également espacées de l'axe de rotation.

2. Installation d'enlèvement de couche selon la revendication 1, **caractérisée en ce que** l'axe de rotation est vertical.

3. Installation d'enlèvement de couche selon la revendication 1 ou 2, **caractérisée en ce que** l'accouplement (7) est disposé au-dessus de la cuve (2) ou dans la partie supérieure de celle-ci.

4. Installation d'enlèvement de couche selon la revendication 3, **caractérisée en ce que** le support (5) est détachable de la cuve (2).

5. Installation d'enlèvement de couche selon l'une quelconque des revendications 1 à 4, **caractérisée en ce que** la paroi intérieure de la cuve (2) est fabriquée d'un matériau électriquement isolant.

6. Installation d'enlèvement de couche selon l'une quelconque des revendications 1 à 5, **caractérisée en ce qu'**un émetteur d'ultrasons (14) est disposé à l'intérieur de la cuve (2).

7. Installation d'enlèvement de couche selon l'une quelconque des revendications 1 à 6, **caractérisée en ce qu'**un dispositif de chauffage et refroidissement (13) est disposé à l'intérieur de la cuve (2).

8. Procédé pour l'opération d'une installation d'enlèvement de couche selon l'une quelconque des revendications 1 à 7, **caractérisé en ce qu'**un porte-pièces (15) consistant au moins principalement d'un matériau électriquement conductible est attaché à l'accouplement (7), l'intérieur de la cuve est rempli avec un électrolyte liquide, et puis, pour l'enlèvement de couche, des potentiels électriques sont appliqués au moins de manière intermittente à l'accouplement (7) et par lequel au porte-pièces (15) en tant qu'électrode d'une part, et à la surface de contre-électrode d'autre part, au moyen du dispositif d'alimentation électrique, alors que le porte-pièces (15), sensiblement totalement immergé dans l'électrolyte, est tourné par rotation de l'accouplement (7) au moyen du dispositif d'entraînement (8).

9. Procédé selon la revendication 8, **caractérisé en ce que** le porte-pièces (15) est un porte-pièces précédemment utilisé dans une installation de revêtement.

10. Procédé selon la revendication 9 pour l'enlèvement de couche des pièces (18), **caractérisé en ce que** le porte-pièces (15) est muni avec les pièces (18) dont lesquelles la couche doit être enlevée.

11. Procédé selon la revendication 10, pour l'enlèvement de la couche des pièces mal couchées (18), **caractérisée en ce qu'**avant l'enlèvement de la couche, le porte-pièces (15) muni des pièces mal couchées (18) est prélevé d'une installation de revêtement et introduit dans l'installation d'enlèvement de couche.

12. Procédé selon la revendication 10 ou 11, pour l'enlèvement et la réapplication de couche à des pièces (18), **caractérisé en ce qu'**après l'enlèvement de couche, le porte-pièces (15) muni des pièces (18) est prélevé de l'installation d'enlèvement de couche et introduit dans une installation de revêtement, et puis les pièces (18) sont nouvellement revêtues dans celle-ci.

13. Procédé selon la revendication 12, **caractérisé en ce que** la porte-pièces (15) munie des pièces (18) est soumise à au moins un traitement, par exemple un lavage, une pulvérisation ou un séchage, entre l'enlèvement de couche et le transfert à l'installation de revêtement.
